# EUROPÄISCHE PATENTSCHRIFT

(11) **EP 2 926 426 B1**
(45) Veröffentlichungstag und Bekanntmachung des Hinweises auf die Patenterteilung: **02.09.2020**
(21) Anmeldenummer: 13796076.1
(22) Anmeldetag: 27.11.2013
(51) Int. Cl.: H02H 3/00, H02H 3/08, H02H 3/10

(54) **SCHALTGERÄT MIT EINER MESSEINRICHTUNG**
SWITCHING DEVICE HAVING A MEASURING APPARATUS
APPAREIL DE COMMUTATION POURVU D'UN DISPOSITIF DE MESURE

(30) Priorität: 27.11.2012 DE 102012111485
(43) Veröffentlichungstag der Anmeldung: 07.10.2015
(73) Patentinhaber: Eaton Intelligent Power Limited, Dublin 4 (IE)
(72) Erfinder: ARENZ, Bernd, 53844 Troisdorf (DE); SCHWARZ, Wolfgang, 50668 Köln (DE); SUCHALLA, Marc, 47198 Duisburg (DE)
(74) Vertreter: Eaton IP Group EMEA
(86) Internationale Anmeldenummer: PCT/EP2013/074899
(87) Internationale Veröffentlichungsnummer: WO 2014/083073

(56) Entgegenhaltungen:
- EP-A2- 1 388 920
- WO-A1-00/76047
- GB-A- 2 460 872
- US-A- 4 672 501
- US-A1- 2011 050 154
- US-B1- 6 417 792

## Beschreibung

Die Erfindung betrifft ein Schaltgerät mit einer Messeinrichtung.

Aus der US-Patentschrift 5,940,257 ist eine Einrichtung zum Messen von mehrphasigen Wechselströmen ist bekannt, mit der eine möglichst genaue Messung der Wechselströme ermöglicht werden soll, um in einem Leistungsverteilungssystem für mehrphasigen Wechselstrom zuverlässig einen Erdschuss detektieren und damit einen Lasttrennschalter noch genauer ansteuern zu können. Die Messeinrichtung weist einen Stromwandler auf, der einen durch eine zu überwachende Leitung des Verteilungssystems fließenden Wechselstrom in einen Messwechselstrom umwandelt. Der Messwechselstrom wird mittels einer Gleichrichterschaltung in einen Gleichstrom umgewandelt, der von einem als Differenzverstärker betriebenen Operationsverstärker verstärkt und einem Kontroller zum Erkennen eines Erdschlusses zugeführt wird.

Die US-Patentschrift 4,672,501, die als nächstliegender Stand der Technik gesehen wird, beschreibt ein Schaltgerät, bei dem Spannungs- und Stromwerte kontinuierlich erfasst und von einem Prozessor überwacht werden, um den elektrischen Zustand eines Stromverteilungssystem zu bestimmen. Beim Auftreten eines Überstroms oder einer Unterspannung wird das Stromverteilungssystem durch die Betätigung eines Leistungsschalters unterbrochen. Wenn der Überstrom- oder Unterspannungszustand nicht mehr besteht, können die Kontakte des Leistungsschalters durch Betätigung eines gesteuerten Relais geschlossen werden. Der Prozessor ist zudem derart konfiguriert, dass es einen Messalgorithmus ausführt, der leistungsbezogene Messungen anhand von in einem digitalisierten ungleichgerichteten Messstrom durchführen kann. Eine ähnliche Schaltung ist aus der europäischen Patentanmeldung EP 1 388 920 A2 bekannt.

Aufgabe der vorliegenden Erfindung ist es nun, ein Schaltgerät vorzuschlagen, mit dem es möglich ist, eine oder mehrere präzise leistungsbezogene Messungen durchzuführen.

Diese Aufgabe wird durch den Gegenstand des unabhängigen Anspruchs gelöst. Weitere Ausgestaltungen der Erfindung sind Gegenstand der abhängigen Ansprüche.

Ein der vorliegenden Erfindung zugrunde liegender Gedanke besteht darin, den ungleichgerichteten Messstrom mit einem Strommessverstärker zu verstärken und einem Kontroller zur weiteren Verarbeitung zur Verfügung zu stellen. Der verstärkte Messstrom enthält Amplituden- und Phasen-Informationen des zu schaltenden Stromes, die zusammen mit weiteren Informationen beispielsweise von einer zusätzlichen Spannungsmessung des zu schaltenden Stroms vom Kontroller für das Durchführen von leistungsbezogenen Messungen verwendet werden können. Durch die Verwendung des ungleichgerichteten Messstromes bleiben im Gegensatz zur üblichen Vorgehensweise mit einer Gleichrichtung des Messstroms die für verschiedene leistungsbezogene Messungen verwertbaren Informationen erhalten. Beispielsweise kann die vom zu schaltenden Strom transportierte Leistung, durch eine Messung über einen bestimmten Zeitraum auch die Energie oder eine Leistungsfaktormessung (cos phi) ermittelt werden.

Eine Ausführungsform der Erfindung betrifft nun ein Schaltgerät mit einem Stromwandler zum potentialfreien Messen eines vom Schaltgerät zu schaltenden Stroms, einem Strommessverstärker, dem eingangsseitig der ungleichgerichtete Messstrom des Stromwandlers zugeführt wird, und einem Kontroller, dem eingangsseitig der Ausgangsstrom des Strommessverstärkers zugeführt wird und der derart konfiguriert ist, den zugeführten Ausgangsstrom zu digitalisieren und anhand der im digitalisierten Ausgangsstrom enthaltenen Informationen und weiterer Informationen eine oder mehrere leistungsbezogene Messungen durchzuführen und die Messergebnisse auszugeben. Das Ausgeben der Messergebnisse wird hierin und im Sinne der vorliegenden Erfindung auch als ein Verarbeiten der Messergebnisse durch den Kontroller selbst verstanden, beispielsweise indem der Kontroller die von ihm ausgeführten Hauptfunktionen durch eine Auswertung oder Einbeziehung der Messergebnisse effizienter ausführt.

Das Schaltgerät kann zum Schalten von mehreren Strömen unterschiedlicher Phasen ausgebildet sein und pro Phase jeweils einen eigenen Stromwandler mit nachgeschalteten Strommessverstärker aufweisen, und der Kontroller kann derart konfiguriert sein, die Ausgangsströme aller Strommessverstärker zu digitalisieren und eine oder mehrere leistungsbezogene Messungen durchzuführen und die Messergebnisse auszugeben.

Der Kontroller kann ferner konfiguriert sein, eine Kalibrierung zum Verringern von durch Stromwandler und/oder Strommessverstärkern auftretenden Toleranzen der Messungen durchzuführen.

Der Strommessverstärker kann einen Differenzverstärker aufweisen, dem eingangsseitig eine an einem Widerstand, durch den der ungleichgerichtete Messstrom des Stromwandlers fliesst, abfallende Spannung zugeführt wird.

Der Kontroller kann ferner konfiguriert sein, um mit den im digitalisierten Ausgangsstrom enthaltenen Informationen eine Fehlerstromberechnung durchzuführen. Ein berechneter Fehlerstrom kann beispielsweise vom Kontroller zum Verbessern einer Schutzfunktion des Schaltgeräts ausgewertet werden.

Weiterhin kann der Kontroller konfiguriert sein, um Schutzfunktionen des Schaltgeräts auszuführen, insbesondere um Schutzfunktionen des Schaltgeräts abhängig von den im digitalisierten Ausgangsstrom enthaltenen Informationen auszuführen. Der Kontroller kann beispielsweise vorwiegend dazu vorgesehen und konfiguriert sein, die Schutzfunktionen des Schaltgeräts auszuführen, und als Zusatzfunktion die leistungsbezogenen Messungen durchzuführen. Die Messungen können vom Kontroller auch ausgewertet werden, um Schutzfunktionen des Schaltgeräts effizienter auszuführen, beispielsweise schneller in einem Fehlerfall oder bei Überschreiten einer Leistungsschwelle Kontakte zu unterbrechen.

Das Schaltgerät kann ein drei- oder vierpoliger Leistungsschalter sein.

Weitere Vorteile und Anwendungsmöglichkeiten der vorliegenden Erfindung ergeben sich aus der nachfolgenden Beschreibung in Verbindung mit den in den Zeichnungen dargestellten Ausführungsbeispielen.

In der Beschreibung, in den Ansprüchen, in der Zusammenfassung und in den Zeichnungen werden die in der hinten angeführten Liste der Bezugszeichen verwendeten Begriffe und zugeordneten Bezugszeichen verwendet.

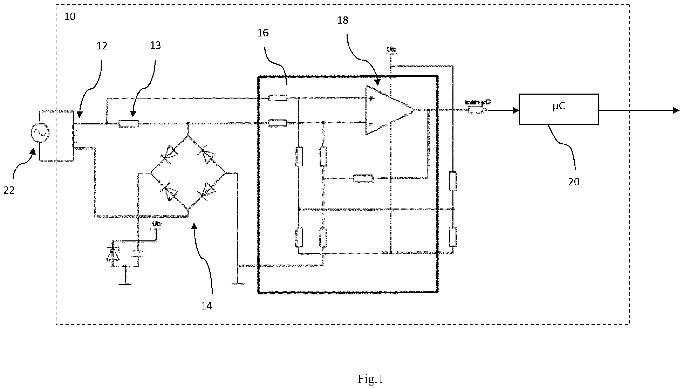

Die Zeichnungen zeigen in
Fig. 1 ein Ausführungsbeispiel eines Leistungsschalters mit einer Messeinreichtung gemäß der Erfindung.

In der folgenden Beschreibung können gleiche, funktional gleiche und funktional zusammenhängende Elemente mit den gleichen Bezugszeichen versehen sein. Absolute Werte sind im Folgenden nur beispielhaft angegeben und sind nicht als die Erfindung einschränkend zu verstehen.

In Fig. 1 ist ein Leistungsschalter 10 zum Schalten eines Wechselstroms 22 gezeigt. In der Darstellung sind nur die für das Verständnis notwendigen Schaltungselemente gezeigt. Die üblicherweise in Leistungsschaltern außerdem vorgesehenen Schaltungselemente wie die Schaltelemente, ein elektromagnetischer Antrieb der Schaltelemente und die Antriebssteuerung sind in Fig. 1 lediglich aus Gründen der besseren Übersichtlichkeit nicht dargestellt.

Zum Versorgen des Leistungsschalters ist ein Stromwandler 12 vorgesehen. Der Stromwandler 22 erzeugt aus dem zu schaltenden Wechselstrom 22 (Primärstrom) einen proportionalen Sekundärstrom. Idealerweise ist bei entsprechendem Betrieb des Stromwandlers 12 der Phasenverschiebungswinkel zwischen Primär- und Sekundärstrom annähernd Null.

Der Sekundärstrom des Stromwandlers 12 speist einen Brückengleichrichter 14, der aus dem Sekundärstrom einen Gleichstrom und eine Gleichspannung Ub zum Versorgen von Schaltungselementen des Leistungsschalters 10 erzeugt.

Vor dem Brückengleichrichter 14 wird über einen Messwiderstand 13, der vom Sekundärstrom durchflossen wird, eine dem Sekundärstrom proportionale Wechselspannung erzeugt, die an den Eingängen eines Operationsverstärkers 18 einer integrierten Schaltung 16mit Strommessverstärker, beispielsweise einem IC MAX9920 von Maxim Integrated, 160 Rio Robles, San Jose, CA 95134 USA, anliegt.

Der Operationsverstärker 18 wird als Differenzverstärker ohne Einsatz phasenverschiebender Elemente betrieben, um den zugeführten Messstrom bzw. die entsprechende Messspannung zur Weiterverarbeitung unter Beibehaltung der ursprünglichen Phaseninformationen des zu schaltenden Wechselstromes 22 zu verstärken.

Der verstärkte Messstrom wird einem Mikrokontroller 20 zugeführt, der zusätzlich zum Ausführen von Schutzfunktionen des Leistungsschalters 10 noch zur Durchführung von Messaufgaben im Leistungsschalter 10 konfiguriert ist. Hierzu kann eine in einem Speicher des Mikrokontrollers 20 abgelegte Firmware vorgesehen sein, die den Kontroller 20 derart konfiguriert, dass er zusätzlich zu den auszuführenden Schutzfunktionen auch verschiedene leistungsbezogene Messungen durchführen kann, und ggf. die Messergebnisse bei der Ausführung der Schutzfunktionen berücksichtigt.

Der dem Mikrokontroller 20 zugeführte verstärkte Messstrom wird zunächst von einem Analog-Digital-Wandler des Kontrollers 20 digitalisiert. Stehen dem Mikrokontroller 20 Daten einer zusätzlichen Spannungsmessung zur Verfügung, können nun verschiedene leistungsbezogene Messungen durchgeführt werden, wie eine Leistungsmessung, eine Energiemessung (bei Betrachtung über einen bestimmten Zeitraum), eine Leistungsfaktormessung (cos phi).

Der in Fig. 1 gezeigte Leistungsschalter 10 ist für das Schalten einer Phase vorgesehen, kann aber prinzipiell zum Schalten mehrerer Wechselstrom-Phasen, beispielsweise von 3 oder 4 Phasen ausgebildet sein (sog. drei- bzw. vierpoliger Leistungsschalter). Um leistungsbezogene Messungen auf bei mehreren zu schaltenden Wechselstrom-Phasen durchführen zu können, können für jede Phase jeweils ein eigener Stromwandler 12 und eigener Strommessverstärker 16 vorgesehen sein, d.h. für 3 oder 4 Phasen werden 3 bzw. 4 Stromwandler und Strommessverstärker im Leistungsschalter implementiert. Dem Mikrokontroller 20 werden dann die Ausgangsströme aller Strommessverstärker zum Durchführen von leistungsbezogenen Messungen zugeführt.

Die Ergebnisse leistungsbezogener Messungen können vom Mikrokontroller 20 beispielsweise an eine Überwachungseinheit ausgegeben, über eine Anzeigeeinrichtung signalisiert und/oder zum Steuern von Funktion des Leistungsschalters 10 (beispielsweise Abschalten von Wechselstrom-Phasen bei Über- oder Unterschreiten vorgegebener Schwellwerte für Leistungen oder bei abweichen gemessener Leistungen von vorgegebenen Leistungsbereichen). Wie bereits oben ausgeführt können die Messergebnisse auch zum Verbessern von Schutzfunktionen herangezogen werden, die der Mikrokontroller 20 im Leistungsschalter ausführt. Weiterhin kann der Mikrokontroller 20 konfiguriert sein, um mit den im digitalisierten Ausgangsstrom enthaltenen Informationen weitere Berechnungen durchzuführen, insbesondere eine Fehlerstromberechnung. Der berechnete Fehlerstrom kann zum Verbessern der vom Mikrokontroller 20 im Leistungsschalter 10 ausgeführten Schutzfunktionen herangezogen werden.

Der Mikrokontroller 20 kann weiterhin durch entsprechende Routinen der Firmware konfiguriert werden, eine Kalibrierung durchzuführen, um durch den Stromwandler 12 und/oder den Strommessverstärker 16 auftretende Toleranzen der Messungen zu verringern. Beispielsweise kann der Leistungsschalter 10 in einem Kalibriermodus Messungen durchführen, wenn kein oder ein definierter Wechselstrom 22 anliegt, und basierend auf den Ergebnissen dieser Messungen bestimmte Korrekturwerte speichern, die aufgrund von Toleranzen des Stromwandlers 12 und/oder Strommessverstärkers 16 verursachte Abweichung der Messergebnisse von erwarteten Messergebnissen korrigieren und bei weiteren Messungen im Normalbetrieb vom Mikrokontroller 20 beim Durchführen des leistungsbezogenen Messungen berücksichtigt werden.

Die Erfindung eignet sich vor allem für den Einsatz in strommessenden Schaltgeräten, deren Funktionsumfang um leistungsbezogenen Messungen oder Energiemessungen erweitert werden kann.

### Bezugszeichen

- 10: Leistungsschalter
- 12: Stromwandler
- 13: Messwiderstand
- 14: Brückengleichrichter
- 16: integrierte Schaltung mit Strommessverstärker
- 18: Operationsverstärker
- 20: Mikrokontroller
- 22: Wechselstrom

## Patentansprüche

1. Schaltgerät mit
- einem Stromwandler (12) zum potentialfreien Messen eines vom Schaltgerät zu schaltenden Stroms (22),
- einem Strommessverstärker (16), dem eingangsseitig der ungleichgerichtete Messstrom des Stromwandlers (12) zugeführt wird, und
- einem Kontroller (20), dem eingangsseitig der Ausgangsstrom des Strommessverstärkers (16) zugeführt wird und der derart konfiguriert ist, den zugeführten Ausgangsstrom zu digitalisieren und anhand der im digitalisierten Ausgangsstrom enthaltenen Informationen und weiterer Informationen von einer zusätzlichen Spannungsmessung des zu schaltenden Stroms eine oder mehrere Leistungs-bezogene Messungen durchzuführen und die Messergebnisse auszugeben,
**dadurch gekennzeichnet, dass**
- der Stromwandler (12) so betrieben wird, dass der Phasenverschiebungswinkel zwischen dem zu schaltenden Strom (22) und dem Messstrom annährend Null ist,
- der Strommessverstärker (16) einen als Differenzverstärker ohne Einsatz phasenverschiebender Elemente betriebenen Operationsverstärker (18) aufweist, dem eingangsseitig eine an einem Widerstand, durch den der ungleichgerichtete Messstrom des Stromwandlers (12) fliesst, abfallende Spannung zum Verstärken unter Beibehaltung der ursprünglichen Phaseninformationen des zu schaltenden Stroms (22) zugeführt wird, und
- der Kontroller (20) konfiguriert ist, die Leistungs-bezogenen Messungen anhand der im digitalisierten Ausgangstrom enthaltenen Amplituden- und Phasen-Informationen des zu schaltenden Stromes durchzuführen, wobei als Leistungs-bezogenen Messungen eine Leistungsmessung, eine Energiemessung und/oder eine Leistungsfaktormessung durchgeführt werden.

2. Schaltgerät nach Anspruch 1,
**dadurch gekennzeichnet, dass**
es zum Schalten von mehreren Strömen unterschiedlicher Phasen ausgebildet ist und pro Phase jeweils einen eigenen Stromwandler mit nachgeschalteten Strommessverstärker aufweist, und der Kontroller derart konfiguriert ist, die Ausgangsströme aller Strommessverstärker zu digitalisieren und eine oder mehrere Leistungs-bezogene Messungen durchzuführen und die Messergebnisse auszugeben.

3. Schaltgerät nach Anspruch 1 oder 2,
**dadurch gekennzeichnet, dass**
der Kontroller ferner derart konfiguriert ist, eine Kalibrierung zum Verringern von durch Stromwandler und/oder Strommessverstärkern auftretenden Toleranzen der Messungen durchzuführen.

4. Schaltgerät nach einem der vorhergehenden Ansprüche.
**dadurch gekennzeichnet, dass**
der Kontroller (20) ferner konfiguriert ist, um mit den im digitalisierten Ausgangsstrom enthaltenen Informationen eine Fehlerstromberechnung durchzuführen.

5. Schaltgerät nach einem der vorhergehenden Ansprüche.
**dadurch gekennzeichnet, dass**
der Kontroller (20) ferner konfiguriert ist, um Schutzfunktionen des Schaltgeräts auszuführen, insbesondere um Schutzfunktionen des Schaltgeräts abhängig von den im digitalisierten Ausgangsstrom enthaltenen Informationen auszuführen.

6. Schaltgerät nach einem der vorhergehenden Ansprüche,
**dadurch gekennzeichnet, dass**
es ein drei- oder vierpoliger Leistungsschalter ist.

## Claims

1. Switching device comprising
- a current transformer (12) for measuring in a potential-free manner a current (22) to be switched by the switching device,
- a current sense amplifier (16), to which the unrectified measurement current of the current transformer (12) is fed on the input side, and
- a controller (20), to which the output current of the current sense amplifier (16) is fed on the input side and which is configured so as to digitalise the fed output current and to perform one or more performance-related measurements on the basis of the information contained in the digitalised output current and further information from an additional voltage measurement of the current to be switched, and to output the measurement results,
**characterised in that**
- the current transformer (12) is operated in such a way that the phase shift angle between the current (22) to be switched and the measurement current is approximately zero,
- the current sense amplifier (16) has an operational amplifier (18) operated without the use of phase shifting elements as differential amplifiers, to which a voltage dropping across a resistor, through which the unrectified measurement current of the current transformer (12) flows, is fed on the input side for amplification while maintaining the original phase information of the current (22) to be switched, and
- the controller (20) is configured to perform the performance-related measurements on the basis of the amplitude and phase information of the current to be switched, said information being contained in the digitalised output current, wherein a performance measurement, an energy measurement and/or a performance factor measurement are carried out as the performance-related measurements.

2. Switching device according to claim 1,
**characterised in that**
the switching device is configured for switching from several currents of different phases and for each phase respectively has its own current transformer with current sense amplifiers connected downstream, and the controller is configured so as to digitalise the output currents of all current sense amplifiers and to perform one or more performance-related measurements and to output the measurement results.

3. Switching device according to claim 1 or 2,
**characterised in that**
the controller is further configured so as to perform a calibration for reducing tolerances of the measurements occurring through current transformers and/or current sense amplifiers.

4. Switching device according to any one of the preceding claims,
**characterised in that**
the controller (20) is further configured to perform a fault current calculation with the information contained in the digitalised output current.

5. Switching device according to any one of the preceding claims,
**characterised in that**
the controller (20) is further configured to carry out protective functions of the switching device, in particular to carry out protective functions of the switching device independently of the information contained in the digitalised output current.

6. Switching device according to any one of the preceding claims,
**characterised in that**
the switching device is a three or four pole circuit breaker.

## Revendications

1. Appareil de commutation avec
- un transformateur de courant (12) pour la mesure sans potentiel d'un courant (22) à commuter par l'appareil de commutation,
- un amplificateur de mesure de courant (16) auquel le courant de mesure non redressé du transformateur de courant (12) est alimenté côté entrée, et
- un contrôleur (20) auquel le courant de sortie de l'amplificateur de mesure de courant (16) est alimenté côté entrée et qui est configuré de sorte que le courant de sortie alimenté est numérisé et qu'une ou plusieurs mesures liées à la puissance sont effectuées sur la base des informations contenues dans le courant de sortie numérisé et d'autres informations provenant d'une mesure de tension supplémentaire du courant à commuter et que les résultats des mesures sont fournis,
**caractérisé en ce que**
- le transformateur de courant (12) est actionné de sorte que l'angle de déphasage entre le courant à commuter (22) et le courant de mesure soit approximativement nul,
- l'amplificateur de mesure de courant (16) présente un amplificateur opérationnel (18) qui fonctionne comme un amplificateur différentiel sans utilisation d'éléments déphaseurs et auquel est amenée, côté entrée, une tension chutant aux bornes d'une résistance traversée par le courant de mesure non redressé du transformateur de courant (12) pour l'amplification tout en conservant les informations de phase initiales du courant (22) à commuter, et
- le contrôleur (20) est configuré pour effectuer les mesures liées à la puissance en utilisant les informations d'amplitude et de phase du courant à commuter contenues dans le courant de sortie numérisé, une mesure de la puissance, une mesure de l'énergie et/ou une mesure du facteur de puissance étant effectuées en tant que mesures liées à la puissance.

2. Appareil de commutation selon la revendication 1,
**caractérisé en ce que**
il est conçu pour commuter une pluralité de courants de phases différentes et présente un transformateur de courant séparé avec un amplificateur de mesure de courant en aval pour chaque phase, et le contrôleur est configuré de sorte que les courants de sortie de tous les amplificateurs de mesure de courant sont numérisés et qu'une ou plusieurs mesures liées à la puissance sont effectuées et les résultats des mesures sont fournis.

3. Appareil de commutation selon la revendication 1 ou 2,
**caractérisé en ce que**
le contrôleur est en outre configuré pour effectuer un étalonnage afin de réduire les tolérances de mesure causées par les transformateurs de courant et/ou les amplificateurs de mesure de courant.

4. Appareil de commutation selon l'une quelconque des exigences précédentes,
**caractérisé en ce que**
le contrôleur (20) est en outre configuré pour effectuer un calcul de courant résiduel avec les informations contenues dans le courant de sortie numérisé.

5. Appareil de commutation selon l'une quelconque des exigences précédentes,
**caractérisé en ce que**
le contrôleur (20) est en outre configuré pour assurer des fonctions de protection de l'appareil de commutation, en particulier pour assurer des fonctions de protection de l'appareil de commutation en fonction des informations contenues dans le courant de sortie numérisé.

6. Appareil de commutation selon l'une quelconque des exigences précédentes,
**caractérisé en ce que**
il est un disjoncteur tripolaire ou quadripolaire
